# EUROPEAN PATENT APPLICATION

(11) **EP 2 840 369 A1**
(43) Date of publication of application: **25.02.2015**
(21) Application number: 13180893.3
(22) Date of filing: 19.08.2013
(51) Int. Cl.: G01J 5/20, H01L 27/146

(54) **Integrated circuit, system and manufacturing method**

(71) Applicant: NXP B.V., 5656 AG Eindhoven (NL)
(72) Inventor: Van Steenwinckel, David, Redhill Surrey RH1 1SH (GB); Besling, Willem, Redhill Surrey RH1 1SH (GB); Humbert, Aurelie, Redhill Surrey RH1 1SH (GB); Le, Kim Phan, Redhill Surrey RH1 1SH (GB); Soccol, Dimitri, Redhill Surrey RH1 1SH (GB); Heil, Stephan, Redhill Surrey RH1 1SH (GB); Donkers, Johannes, Redhill Surrey RH1 1SH (GB); Attenborough, Karen, Redhill Surrey RH1 1SH (GB); Daamen, Roel, Redhill Surrey RH1 1SH (GB); Gravesteijn, Dirk, Redhill Surrey RH1 1SH (GB)
(74) Representative: Hardingham, Christopher Mark

(57) **Abstract**

Disclosed is an integrated circuit (100) comprising a cavity (52) defined over a substrate (10) and a membrane (42, 50) arranged to be exposed to infrared radiation suspended over said cavity, said membrane comprising a conductive body (42) and an infrared radiation absorbing polymer (50) covering said conductive body such that the conductive body is shielded from said radiation by said polymer, said conductive body being conductively coupled to a pair of electrodes. A body detection system including such an IC and a method of manufacturing such an IC are also disclosed.

## Description

The present invention relates to an IC comprising a bolometer.

The present invention further relates to a motion detection system comprising such an IC.

The present invention yet further relates to a method of manufacturing such an IC.

Bolometry makes use of the absorption of long-wave infrared (LWIR) radiation in one or more suitable sensor elements, which are sometimes referred to as (bolometer) pixels. Multiple sensor elements or pixels, which for instance may be arranged in sensor grids or arrays may be used for this purpose. LWIR radiation is the characteristic radiation that people - and other bodies at temperatures around 30-50 degrees - emit, as predicted by blackbody radiation theory. The absorption of the LWIR radiation in the bolometer pixels results in a temperature increase in these pixels that is proportional to the amount of incident LWIR radiation. The temperature increase is then translated into a resistance change that can be measured electrically, typically by utilizing the non-zero temperature coefficient of resistance of a material integrated in these pixels.

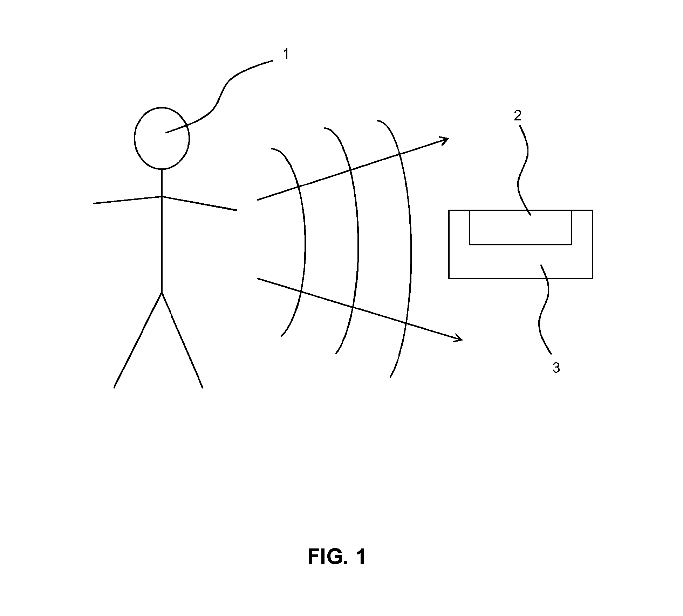

The principle of bolometry is schematically depicted in FIG. 1 of the accompanying drawings. As can be understood from FIG. 1, a body 1 such as a human body entering a contained area emits long wave infra-red (LWIR) radiation as represented by the arcs and arrows shown in the Figure. A bolometer 2 on a device 3 absorbs the emitted LWIR radiation and as a result, its temperature rises proportionately to the quantity of incident LWIR. This increase in temperature is translated into a resistance change which can be measured electrically, as explained above. The material used for the resistive measurement may directly absorb the LWIR radiation, i.e. may be directed heated by the LWIR radiation.

As such, bolometry is passive, low-power technology that offers good lateral resolution. This resolution can be further improved by incorporation of optical elements, e.g. a lens such as a Fresnel lens on top of the one or more sensing elements or pixels.

With the ongoing diversification of on-chip functionality, it has become of significant commercial interest to include sensor structures in the design of ICs, as electronic devices equipped with such ICs can perform a wide range of tasks. It is already known to include a wide variety of sensors, e.g. moisture sensors, gas sensors such as CO₂ sensors, temperature sensors and so on in the design of an IC. Such sensors may for instance be formed in a cost-effective manner in the backend process of the IC manufacture, where such sensor may be formed partially in or over the metallization stack of the IC, e.g. on the passivation layer stack. It can be readily understood that the inclusion of bolometers in the IC design is also commercially interesting.

However, such integration is not straightforward. Many materials used in IC manufacture, such as materials used in CMOS processes have relatively high thermal conductivity. Therefore, the thermal coupling between the bolometer and its surroundings can significantly reduce the resolution of the bolometer as a significant portion of the heat generated by the LWIR absorption dissipates to these surroundings. This leads to small resistance changes in the conductive material of the bolometer, which may be difficult to translate into accurate sensor readings.

Moreover, conductive materials showing good LWIR absorption characteristics may not be compatible with standard IC manufacturing processes such as a CMOS manufacturing process, a SiGe-based manufacturing process, a GaAs-based manufacturing process and so on. Integration of such materials into the manufacturing flow may be cost-prohibitive.

The present invention seeks to provide an IC comprising a sensitive and cost-effective bolometer structure.

The present invention further seeks to provide a motion sensor system including such an IC.

The present invention yet further seeks to provide a method of manufacturing such an IC.

Embodiments of the present invention are defined by the claims.

According to an aspect, there is provided an integrated circuit (IC) comprising a cavity defined over a substrate and a membrane arranged to be exposed to infrared radiation suspended over said cavity, said membrane comprising a body having a temperature-dependent electrical resistivity and an infrared radiation absorbing polymer covering said body such that the conductive body is shielded from direct exposure to said radiation by said polymer, said body being conductively coupled to a pair of electrodes.

Such an IC benefits from the fact that the bolometer structure defined by the membrane is thermally decoupled from the substrate whilst at the same time the polymer supporting the body acts as a collector of the LWIR radiation and heating element for the body, such that the body itself does not need to be capable of absorbing LWIR radiation. This facilitates the integration of a bolometer with good resolution in an IC in a cost-effective manner, as the materials used to form the bolometer may be materials commonly used in the manufacturing process of the IC.

The IC may comprise a pair of contacts defining said electrodes, and wherein the membrane is suspended between a pair of vias, each via extending from one of said contacts. The contacts may act as landing pads for the vias. The contacts may for instance be formed in the metallization stack of the IC or on top of the passivation layer (stack) of the IC, which passivation layer may be formed over the metallization stack.

The IC may advantageously comprise a reflective element in said cavity, said reflective element facing the body. This further improves the absorbance of IR radiation, i.e. LWIR radiation, by the polymer, thus further improving the resolution of the bolometer structure. The reflective element effectively acts as a mirror and may comprise a metal layer portion such as an aluminium layer portion, as aluminium has good reflective properties.

In an embodiment, the conductive body is shaped as a plate or a line such as a metal line or a line of another electrically conductive material. A meandering line is particularly advantageous as it has a relatively small diameter and relative large length such that its thermal resistance is relatively high, which further reduces heat loss to its surroundings. Such meanders further facilitate the removal of sacrificial material to define the cavity underneath the membrane.

In an embodiment, the polymer is polyimide, which has a high absorbance of LWIR radiation and is commonly used in IC manufacturing processes, e.g. CMOS processes.

The IC may further comprise a processing element conductively coupled to the pair of electrodes, said processing element being adapted to periodically measure the electrical resistance of the body. This allows for the generation and processing of motion detection signals on a single chip.

In an embodiment, the IC may be packaged in a package, which may be a vacuum package. Such a vacuum package has the additional advantage that the thermal insulation of the bolometer on the IC is further improved, which further improves the resolution of this sensor.

According to another aspect, there is provided a body detection system comprising the IC or package according to an embodiment of the present invention. The IC may for instance be integrated in a sensor module of a modular body detection system comprising a plurality of sensor modules and a central controller or may form part of a system contained in a single device. The single device may be a dedicated motion detection system or may offer motion detection along other functionalities. The single device may for instance be an electronic device such as a smart phone, a portable computer, a personal digital assistant, and so on. The IC may for instance be integrated in the device and be user-activated, for instance to provide body sensing in the absence of the user, in order to detect unauthorised access to an environment in which the electronic device is located. According to yet another aspect, there is provided a method of manufacturing an integrated circuit (IC), comprising providing a substrate; forming a first contact and a second contact over said substrate; forming a sacrificial layer over said substrate; forming trenches in said sacrificial layer to expose part of said first contact and said second contact respectively; lining said trenches and said sacrificial layer with a material having a temperature-dependent electrical resistivity; patterning the material on the sacrificial layer; depositing an infrared radiation absorbing polymer over the resultant structure; patterning said polymer such that the patterned polymer covers the patterned material; and selectively removing the sacrificial material, thereby forming a cavity underneath the patterned polymer. This allows for the manufacture of an IC including a high-resolution bolometer in a cost-effective manner, thereby providing an IC for which the readout of bolometer signals can be achieved in an efficient way with good signal to noise ratios.

In an embodiment, the method further comprises providing a passivation layer over the substrate, wherein said sacrificial layer is formed on the passivation layer. his allows for the bolometer to be formed in the backend process, thereby achieving a large flexibility in the materials used to form the bolometer because backend processes are typically low-temperature processes, thereby reducing the risk of materials being damaged by thermal budgets..

The first contact and the second contact may be formed in a metallization stack of the integrated circuit, and wherein the step of forming said trenches comprises forming said trenches in the sacrificial layer and the passivation layer. Alternatively, the first contact and the second contact may be formed on the passivation layer and be for instance connected to the metallization stack using vias extending through the passivation layer.

In an embodiment, said lining step comprises lining said trenches and said sacrificial layer with a layer stack including a conductive material layer, wherein said conductive material layer optionally is an infrared radiation absorbing conductive material layer. This further increases the sensitivity of the bolometer. Ideally, such a LWIR-absorbing material should be compatible with the manufacturing process of the IC as previously explained.

Embodiments of the invention are described in more detail and by way of non-limiting examples with reference to the accompanying drawings, wherein:
FIG. 1 schematically depicts the bolometry principle;
FIG. 2 schematically depicts a manufacturing method of an IC comprising a bolometer in accordance with an embodiment of the present invention;
FIG. 3 schematically depicts an aspect of a manufacturing method of an IC comprising a bolometer in accordance with another embodiment of the present invention;
FIG. 4 schematically depicts an IC comprising a bolometer in accordance with yet another embodiment of the present invention; and
FIG. 5 schematically depicts a motion detection system according to an embodiment of the present invention.

It should be understood that the Figures are merely schematic and are not drawn to scale. It should also be understood that the same reference numerals are used throughout the Figures to indicate the same or similar parts.

In the following description, embodiments will be described based on an integrated circuit (IC) manufactured in a CMOS process. It is pointed out that this is by way of non-limiting example only, and that in alternative embodiments, the IC may be realized in any suitable alternative technology, such as for instance bipolar technologies, silicon germanium-based technologies, gallium nitride-based technologies and so on.

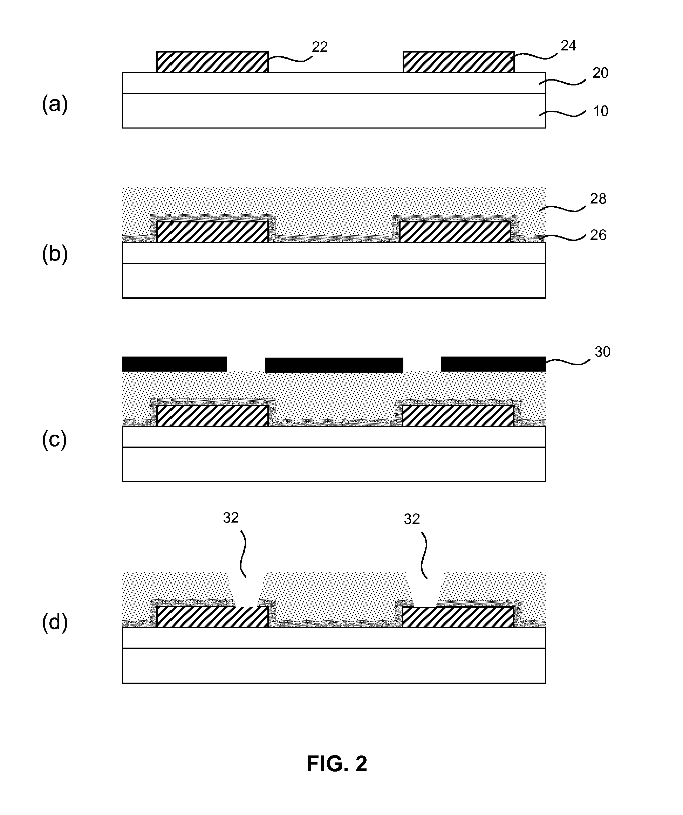

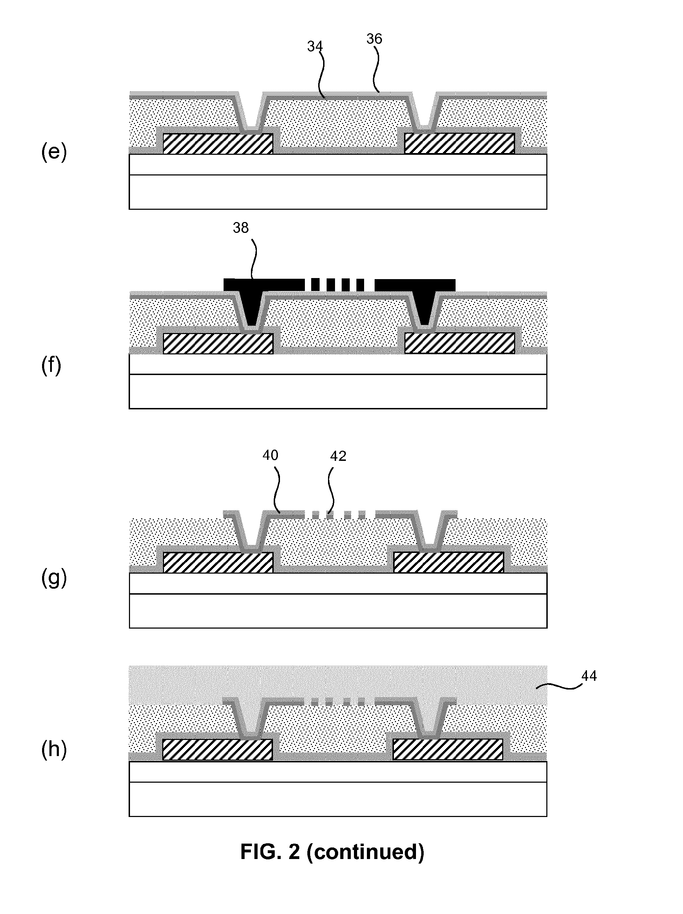

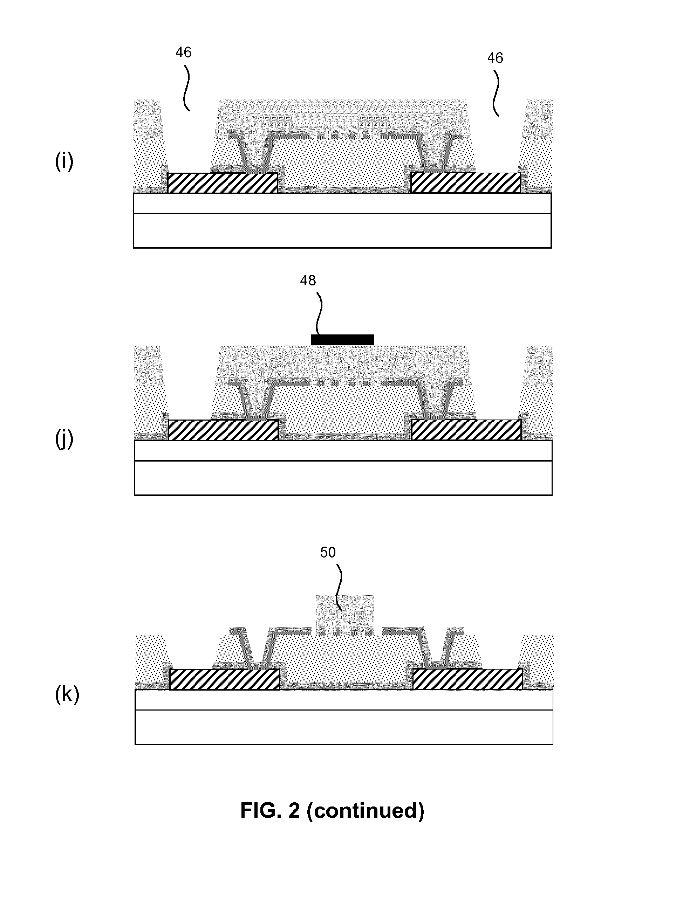

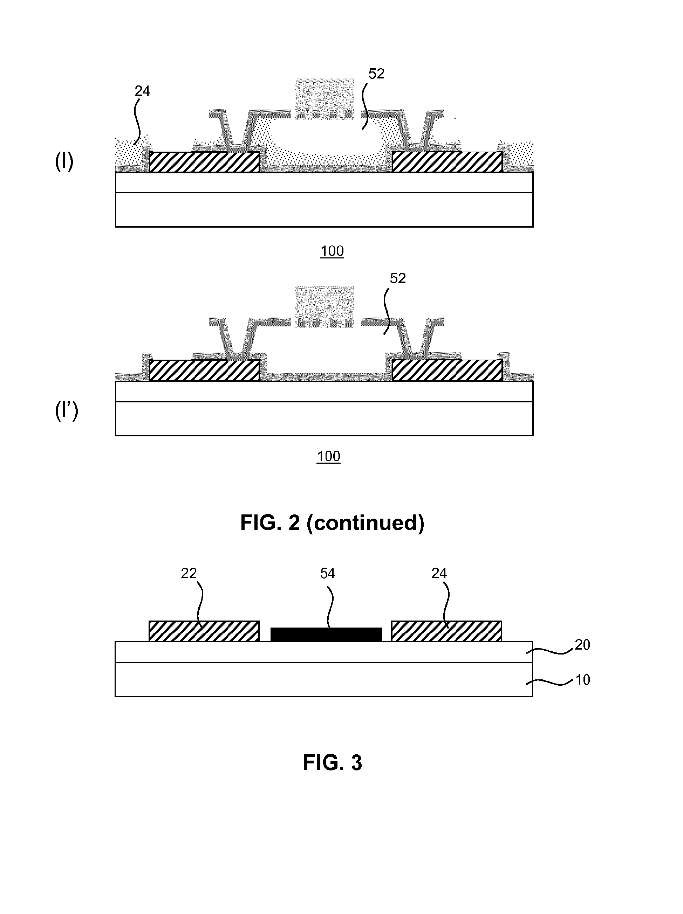

FIG. 2 schematically depicts a method of manufacturing an IC in accordance with an embodiment. A cross-section of the IC is shown for the various manufacturing steps. The method commences in step (a) with the provision on a substrate 10, which may be any suitable substrate, e.g. a silicon or silicon-on-insulator substrate in a CMOS process or a different type of substrate in case of an alternative process as previously explained. The substrate 10 may carry a plurality of circuit elements (not shown), some of which for instance may define a bolometer processing element as will be explained in more detail later.

A passivation layer 20 is typically provided over the substrate 10 to protect the circuit elements on the substrate 10 from external exposure. The passivation layer 20 may comprise any suitable material, e.g. silicon oxide, silicon rich oxide, silicon nitride, combinations thereof, and so on. The passivation layer 20 may also be a passivation layer stack comprising multiple passivation layers 20, e.g. at least one silicon oxide layer and at least one silicon nitride layer, or any other suitable material for such a passivation layer 20. It is noted that the passivation layer(s) 20 are typically electrically insulating layers. Although in step (a) the passivation layer 20 is shown directly on the substrate 10, it should be understood that this is by way of non-limiting example only and that one or more layers may be present in between the substrate 10 and the passivation layer 20 as will be explained in more detail later.

A first contact 22 and a second contact 24 may be formed on the passivation layer 20. The first contact 22 and the second contact 24 are electrically conductive and may be made from any suitable electrically conductive material. For instance, in a CMOS process, the first contact 22 and the second contact 24 may be Al contacts, Cu contacts Al/Cu contacts and so on. Although not specifically shown, it should nevertheless be understood that the first contact 22 and the second contact 24 may be further connected to a processing element underneath the passivation layer 20 in any suitable manner, e.g. by means of vias.

Next, as shown in step (b), an etch stop layer 26 is provided over the passivation layer 20, the first contact 22 and a second contact 24. The etch stop layer 26 may for instance be a Ta₂O₅ layer or any other suitable etch stop material. The use of a Ta₂O₅ layer has the further advantage that the layer also serves as a moisture barrier and an adhesion layer. The etch stop layer 26 may be formed in any suitable manner, e.g. using vapour deposition techniques. A sacrificial layer 28 is subsequently grown over the etch stop layer 26. This layer will be at least partially removed at a later stage to form a cavity underneath the bolometer structure. Also, the thickness of the sacrificial layer 28 may be tuned to control the height of the air gap or cavity, thereby tuning the thermal insulation of the bolometer sensor structure over the cavity, as will be explained in more detail below. Sacrificial materials are of course well-known per se and it is simply noted that any suitable sacrificial material, e.g. a silicon oxide such as SiO₂, may be used.

In step (c), a photoresist 30 is formed over the sacrificial layer 28, e.g. through spincoating. Suitable photoresist materials are well-known per se and it is simply stated that any suitable photoresist material may be used, such as g-line, i-line or DUV photoresists, e.g. Novolac. The photoresist 30 is subsequently developed to yield a patterned photoresist layer in which areas of the sacrificial layer 28 over the first contact 22 and the second contact 24 are exposed.

The method subsequently proceeds to step (d), in which the sacrificial layer 28 and the etch stop layer 26 are selectively removed as per the patterned photoresist layer 30 to expose parts of the first contact 22 and the second contact 24 by the formation of trenches 32. The selective removal may for instance be achieved by a suitable etch recipe or a sequence of suitable etch recipes to consecutively remove the sacrificial layer 28 and the etch stop layer 26. For instance, a dry etch recipe such as a fluoride-based reactive ion etch recipe may be used to remove SiO₂ as the sacrificial material 28 and Ta205 as the etch stop layer 26.

Next, the resist layer 30 is removed as shown in step (e), after which a bolometer sensor material is deposited over the sacrificial layer 28 and in the trenches 32 to line the exposed surfaces of the sacrificial layer 28 and the trenches 32. In the context of the present invention, the bolometer sensor material is the material of which the temperature-dependent electrical resistance is measured to detect the exposure of the sensor to LWIR radiation. The bolometer sensor material may be deposited as a single layer or as a stack of layers. As shown in step (e), a first layer 34 and a second layer 36 are deposited. If deposited in a CMOS process, suitable materials for the first layer 34 and the second layer 36 may include Al, Ti, TiN, Ti/TiN, W, amorphous Si, which may be doped with suitable impurities to increase its electrical conductivity, polycrystalline SiGe, and so on. In an embodiment, the first layer 34 comprises Ti, TiN or Ti/TiN and the second layer 36 comprises tungsten (W). A Ti layer may for instance act as a glue layer and a TiN layer may for instance act as a barrier layer, as is well-known per se. The formation of such layers is well-known per se and will not be further explained for reasons of brevity only.

The thickness of the (upper) bolometer sensor material layer 36 and if present the lower bolometer sensor material layer 34 may be tuned to reduce the risk of cracking of these layers, in particular in locations where a large topography and/or stresses are present.

The method subsequently proceeds to step (f) in which a further photoresist 38 is formed over the (upper) bolometer sensor material layer 36, e.g. through spincoating. It is reiterated that any suitable photoresist material may be used, such as i-line resists or DUV resists. The further photoresist 38 is subsequently developed to yield a patterned photoresist layer in which areas of the (upper) bolometer sensor material layer 36 are exposed. Particularly, the areas of the (upper) bolometer sensor material layer 36 in the trenches and to form a (electrically conductive) body used for the resistive measurements during operation of the bolometer are protected by the patterned further photoresist 38.

In step (g), the exposed portions of the (upper) bolometer sensor material layer 36 and if present the lower bolometer sensor material layer 34 are etched away using one or more suitable etch recipes, e.g. dry etch recipes e.g. based on SF₆ chemistry, to form the vias 40 in the trenches 32 and the body 42 on the sacrificial material layer 28. It is noted that in a preferred embodiment, the body 42 having a temperature-dependent electrical resistivity has the shape of a meandering line, as shown in step (g). This increases the resistivity of the body 42 and at the same time reduces the thermal coupling of the body 42 with its environment. It should however be understood that the body 42 may have any suitable shape or form, such as a plate or a disk. It is further noted that the mechanical stability of the bolometer may be further improved by the inclusion of additional vias 40 in the bolometer structure, such that it should be understood that two vias 40 are shown by way of non-limiting example only. The bolometer structure may include any suitable number of vias. It should be understood that the body 42 preferably is an electrically conductive body although any material of which a temperature-dependent electrical resistance can be measured may be used.

The method subsequently proceeds to step (h), in which a polymer layer 44 is formed over the intermediate structure resulting from the completion of step (g), e.g. through spincoating or any other suitable deposition technique. The polymer typically absorbs infrared radiation, and in particular LWIR radiation. Any suitable polymer matching these characteristics may be used. For instance, polyimide has the required characteristics and is commonly used in semiconductor manufacturing processes, e.g. CMOS manufacturing processes. Other example LWIR absorbing polymers for instance include black or clear poly (methylmecracylate) (PPMA), polypropylene (PP), polyethylene terephthalate (PET), polybutylene terephthalate (PBT), (high-impact) polystyrene (PS), poly (oxymethylene) (copolymer) (POM) and polyamide, although many more LWIR-absorbing polymers will be known to the skilled person. In an embodiment, the polymer layer 44 is a polyimide layer.

The thickness of the polymer layer 44 may be tuned to maximize LWIR absorbance and control the flexibility or rigidity of the membrane including the polymer layer 44 and the bolometer sensor material layer 36 and 24 if present.

In optional step (i), further trenches 46 may be formed, e.g. by using one or more suitable dry etch recipes, through the polymer layer 44 and the sacrificial layer 28 to expose the first contact 22 and the second contact 24 such that respective external contacts to the first contact 22 and the second contact 24 may be formed when finalizing the IC. Although not specifically shown, it will be understood that such further trenches 46 may be formed using a patterned resist or mask. This step may be omitted if the bolometer is connected internally to a processing element underneath the passivation layer, e.g., through vias connected to the contacts 22 and 24 and extending through the passivation layer 20.

A further patterned resist 48 is formed over the polymer layer 44 in step (j) for patterning the polymer layer 44 such that the body 42 is covered and supported by the patterned polymer layer. Any suitable resist material may be used as previously explained. The polymer layer 44 is subsequently patterned in step (k) to yield a polymer layer portion 50 covering the body 42 such that the body 42 is shielded from direct exposure to LWIR radiation by the polymer portion 50. Polymer patterning such as polyimide patterning is well-known per se such that it suffices to state that the polymer layer 48 may be patterned in any suitable manner.

The bolometer structure is finalized in the next method step by the removal of the sacrificial material 28 from the IC. Step (l) and step (l') show alternative embodiments of such a removal step. In step (l), a mild oxide etch is performed in case of the sacrificial material being an oxide, e.g. silicon oxide, which ensures that the bolometer structure formed by the bolometer material layers 34 (if present) and 36 and the covering LWIR absorbing polymer layer portion 50 is thermally decoupled from the layers below this structure by the formation of a cavity or air gap 52 underneath the bolometer structure. In other words, an air gap is introduced in between the bolometer structure and the passivation layer 20 to realize this thermal decoupling.

In step (l), some sacrificial material may remain present on the passivation layer. If this is undesirable, a more aggressive oxide etch may be performed as shown in step (l'), in which all the sacrificial material is removed. This obviously increases the risk of unwanted damage to underlying structures of the IC, which may require the etch stop layer 26 to have an increase thickness compared to the thickness of the etch stop layer 26 when using a mild oxide etch. The IC 100 subsequently may be finalized and packaged using conventional techniques, which will not be described in further detail for the sake of brevity only. It will be understood that in the finalized IC 100, at least the polymer portion 50 will be exposed such that it can harvest incident (LWIR) radiation. Optical elements, e.g. a lens such as a Fresnel lens, may be present over the polymer portion 50 to increase the amount of LWIR radiation collected by the polymer portion 50.

Upon completion, an IC 100 is obtained in which a bolometer structure including a body 42, e.g. an electrically conductive body, covered by a polymer layer portion 50 is suspended over a cavity or air gap 52 in between vias 40, which vias 40 conductively couple the body 42 to the first contact 22 and the second contact 24 respectively, such that the temperature-dependent resistance of the body 42 may be measured via the first contact 22 and the second contact 24. This may be achieved externally, e.g. using the external contacts formed in the further trenches 46 or may be done on-chip, in which case the IC 100 may comprise a processing element (not shown) conductively coupled to the first contact 22 and the second contact 24 and adapted to periodically measure the temperature-dependent electrical resistance of the body 42 and derive the detection of LWIR radiation from the (change in) temperature corresponding to the measured electrical resistance. Such a processing element may take any suitable shape, e.g. a dedicated microcontroller or a general purpose processor programmed to perform such periodic evaluations. Other suitable embodiment of such a processing element will be immediately apparent to the skilled person.

At this point, it is noted that the polymer portion 50 acts as a heating element for the body 42, i.e. is thermally coupled to the body 42. Because the polymer portion 50 absorbs the LWIR radiation and heats the body 42, it is no longer necessary that the conductive body 42 is capable of absorbing LWIR radiation. This significantly increases the flexibility of the materials used to form the body 42, e.g. the (upper) bolometer sensor material layer 36 and if present the lower bolometer sensor material layer 34, and facilitates the use of conductive materials readily available in the IC process technology of choice, such as a CMOS process or any other suitable process as previously explained. It should be understood for the avoidance of doubt that it is of course perfectly possible that both the polymer portion 50 and the body 42 are capable of absorbing LWIR radiation.

In embodiments of the present invention, the polymer portion 50 shields the body 42 from direct exposure to LWIR radiation. It should however be understood that the term 'shielding' is intended to cover embodiments where the LWIR radiation is partially absorbed by the polymer portion 50 such that the body 42 may be indirectly exposed to some LWIR radiation travelling through the polymer portion 50.

Although the IC 100 is shown to have only a single bolometer pixel, i.e. a single bolometer structure suspended over a single cavity 52, it should be understood that this is by way of non-limiting example only. The IC 100 may comprise a plurality of such bolometer pixels, which may be arranged in a grid or array and may combine to define a multi-pixel bolometer, as is known per se. Moreover, not every bolometer pixel requires a separate cavity 52; at least some of the bolometer pixels may be defined by separate bolometer structures suspended over a shared cavity 52.

It should also be understood that several variations to the embodiment shown in FIG. 2 may be considered without departing from the teachings of the present invention. An alternative embodiment is shown in FIG. 3, in which step (a) as shown in FIG. 2 is extended by the provision of a reflective element 54 for reflecting LWIR radiation penetrating the cavity 52 back towards the bolometer structure formed by the body 42, e.g. an electrically conductive body, and the polymer portion 50, thereby increasing the absorbance yield of the bolometer structure and thus improving the resolution of the bolometer.

In at least some embodiments, the distance between the reflective element 54 and the bolometer layers 34 and 36 are tuned such that an optical cavity such as a Fabry-Perot cavity or etalon is formed between the reflective element 54 and the bolometer layers 34 and 36. In particular, the distance should be tuned to be ¼ of the typical LWIR wavelength of interest. For instance, for detection in the ambient temperature domain, e.g. 18-30°C, the typical LWIR wavelength is 10µm, such that the distance between the reflective element 54 and the bolometer layers 34 and 36 should be 2.5µm. The distance can be controlled by selecting a suitable thickness of the sacrificial layer 28.

The reflective element 54 may be made of any suitable reflective material, e.g. a reflective metal such as aluminium. In an embodiment, the reflective element 54 is made of the same material as the first contact 22 and the second contact 24, which has the advantage that the metal portions on the passivation layer 20 may be formed in a single deposition and subsequent patterning step. The IC 100 according to this embodiment may subsequently be finalized as shown in steps (b)-(l) or (l') as shown in FIG. 2.

At this point, it is noted that it should be understood that variations to the process flow described in FIG. 2 and 3 are possible without departing from the scope of the present invention. For instance, in an alternative embodiment, steps (h) and (i) may be interchanged, such that the further trenches 46 are formed before the deposition and development of the polymer layer 44 in such a way that the polymer layer 44 resides on the bolometer structures 34, 36 only after step (k). This for instance makes the underetch of the sacrificial material 28 easier. Other variations to the disclosed process flow, e.g. feasible changes in the order of process steps, will be apparent to the skilled person.

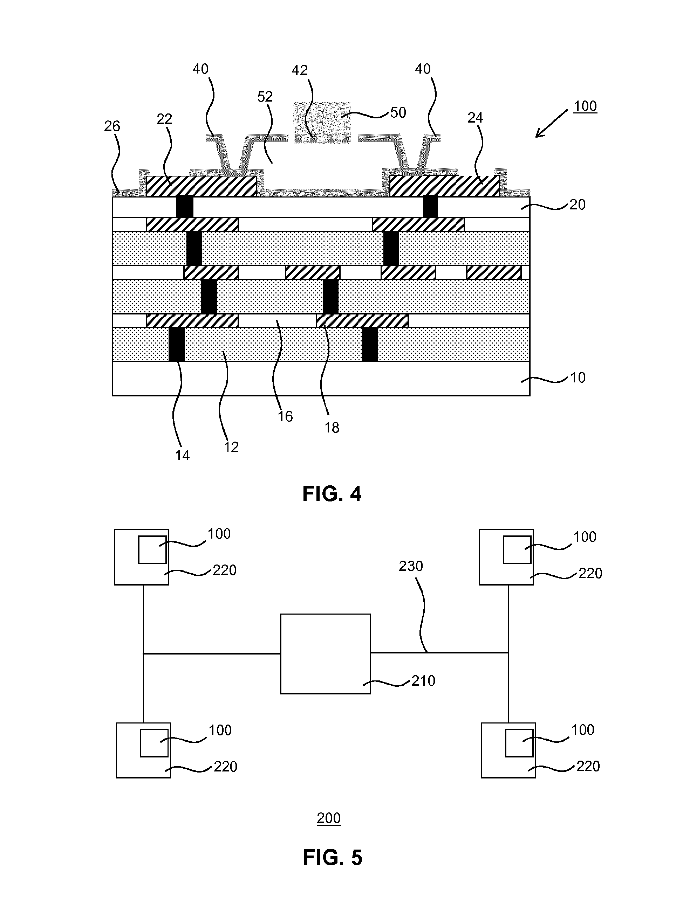

It has been previously mentioned that in certain embodiments, the IC 100 may comprise further layers in between the substrate 10 and the passivation layer 20. This may be any suitable layer or combination of layers, which layers may include any suitable further structures. For instance, in an embodiment, the IC 100 comprises a metallization stack in between the substrate 10 and the passivation layer 20, as shown in FIG. 4, with the vias 40, the bolometer structure including the polymer portion 50 and the body 42 having a temperature-dependent electrical resistivity, e.g. an electrically conductive body, and the air gap 52 being formed on top of the passivation layer 20 over the metallization stack. The bolometer on the passivation layer may be formed as per the method shown in FIG. 2.

The metallization stack typically comprises one or more electrically insulating layers 12 that electrically insulate patterned metal portions 18 in different layers of the metallization stack from each other. Vias 14 may extend through the electrically insulating layers 12 to electrically interconnect patterned metal portions 18 in different layers of the metallization stack to each other in order to provide the desired interconnections between circuit elements (not shown) on the substrate 10 of the IC 100. Patterned metal portions 18 in a single layer may be electrically insulated from each other by further electrically insulating layers 16, which may be of the same material or of a different material than the electrically insulating layers 12.

For instance, in a CMOS technology, each metal layer 18 and each dielectric layer 12 and/or 16 may consist of a number of stacked sub-layers, such as for instance in a CMOS-14 process in which stacks of Ti, TiN, AlCu and TiN may be used to define a single metal layer in the metallization stack. Similarly, the conductive conduits, e.g. vias 14, may be formed from more than a single material. For instance, in the aforementioned CMOS technology, a via may be formed by a TiN liner and a W plug. Each of the dielectric layers may also comprise more than a single layer. For instance, such a dielectric layer may be a stack comprising FSG (fluorosilicate glass), Si02 and HDP oxide (High Density Plasma) any other suitable dielectric material combination. Other suitable materials may also be used.

Further modifications of the design of the IC 100 will be apparent. For instance, rather than having the first contact 22 and the second contact 24 on the passivation layer, metal portions 18 in the upper metal layer of the metallization stack may be used as these contacts, in which case the trenches 32 and 46 extend through the passivation layer 20 and terminate on these metal portions 18, such that vias 40 extend through the passivation layer 20, with the bolometer structure being suspended between the vias 40 over a cavity 52 over the passivation layer 20. In this embodiment, the reflective element 52 may be formed in a separate step on the passivation layer 20.

In at least some embodiments, the IC 100 may be packaged in any suitable manner. IC packaging is well-known per se and will not be explained in further detail for the sake of brevity only. The package may be a vacuum package. This has the additional advantage that the thermal insulation of the bolometer on the IC 100 is further improved, which further improves the resolution of this sensor. The vacuum package may for instance be realized using wafer bonding, thereby providing a wafer-level vacuum package, or by insertion of the IC 100 in a discrete vacuum package.

FIG. 5 schematically depicts a body sensor system 200 according to an embodiment. The body sensor system 200 comprises a plurality of sensor modules 220, each including at least one IC 100 according to one or more embodiments of the present invention. The sensor modules 220 are communicatively coupled to a central controller 210 via communication channels 230, which may be wired or wireless channels. The body sensor system 200 may for instance be a motion detection system or the like to detect the presence of a body such as a human body in an environment, e.g. a room or the like, in which a sensor module 220 is placed. The bolometer of the IC 100 can detect the presence of such a body by detection of the LWIR radiation transmitted by such a body, as previously explained with the aid of FIG. 1. Upon such detection, the sensor module 220 may signal the central controller 210, which central controller 210 may be configured to take appropriate action upon receiving such a signal, e.g. generate a notification or an alarm, which may be an audible alarm or a silent alarm or notification relayed to a remote location, e.g. to a remote user or observer, for instance by way of an automated message or telephone call.

Such a body sensor system 200 may instead be integrated into a single device, e.g. an electronic device such as a smart phone, a portable computer, a personal digital assistant, and so on, in which the IC 100 may provide the sensing functionality only, in which case the IC 100 may be coupled to a further processing element in the electronic device for performing the periodic monitoring of the bolometer in the IC 100, or in which the IC 100 instead may also perform the periodic monitoring as previously explained. Other variations will be immediately apparent to the skilled person.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. An integrated circuit (100) comprising a cavity (52) defined over a substrate (10) and a membrane (42, 50) arranged to be exposed to infrared radiation suspended over said cavity, said membrane comprising a body (42) having a temperature-dependent electrical resistivity and an infrared radiation absorbing polymer (50) covering said body such that the body is shielded from direct exposure to said radiation by said polymer, said body being electrically conductively coupled to a pair of electrodes.

2. The integrated circuit (100) of claim 1, further comprising a pair of contacts (22, 24) defining said electrodes, and wherein the membrane (42, 50) is suspended between a pair of vias (40), each via extending from one of said contacts.

3. The integrated circuit (100) of claim 1 or 2, further comprising a reflective element (54) in said cavity (52), said reflective element facing the conductive body (42).

4. The integrated circuit (100) of any of claims 1-3, wherein the body (42) is shaped as a plate or aline such as a meandering line.

5. The integrated circuit (100) of any of claims 1-4, wherein the polymer (50) is polyimide.

6. The integrated circuit (100) of any of claims 1-5, further comprising a metallization stack on the substrate (10), and wherein the cavity (52) is formed over the metallization stack.

7. The integrated circuit (100) of claim 6, wherein said contacts (22, 24) are formed in said metallization stack.

8. The integrated circuit (100) of any of claims 1-7, wherein the cavity (52) is formed over a passivation layer (20) of the IC.

9. The integrated circuit (100) of any of claims 1-8, further comprising a processing element conductively coupled to the pair of electrodes, said processing element being adapted to periodically measure the electrical resistance of the conductive body (42).

10. A package comprising the integrated circuit of any of claims 1-9, wherein the package optionally is a vacuum package.

11. A body detection system (200) comprising the integrated circuit (100) of any of claims 1-9 or the package of claim 10.

12. A method of manufacturing an integrated circuit (100), comprising:
providing a substrate (10);
forming a first contact (22) and a second contact (24) over said substrate;
forming a sacrificial layer (28) over said substrate;
forming trenches (32) in said sacrificial layer to expose part of said first contact and said second contact respectively;
lining said trenches and said sacrificial layer with a material (34, 36) having a temperature-dependent electrical resistivity;
patterning the material on the sacrificial layer;
depositing an infrared radiation absorbing polymer (44) over the resultant structure;
patterning said polymer such that the patterned polymer (50) covers the patterned material (42); and
selectively removing the sacrificial material, thereby forming a cavity (52) underneath the patterned polymer and the patterned material.

13. The method of claim 12, further comprising providing a passivation layer (20) over the substrate (10), wherein said sacrificial layer (28) is formed on the passivation layer.

14. The method of claim 13, wherein the first contact (22) and the second contact (24) are formed in a metallization stack of the integrated circuit (100), and wherein the step of forming said trenches (32) comprises forming said trenches in the sacrificial layer (28) and the passivation layer (20).

15. The method of any of claims 12-14, wherein said lining step comprises lining said trenches (32) and said sacrificial layer (28) with a layer stack including a conductive material layer (34, 36), wherein said conductive material layer optionally is an infrared radiation absorbing conductive material layer.
